# EUROPEAN PATENT APPLICATION

(11) **EP 4 257 999 A1**
(43) Date of publication of application: **11.10.2023**
(21) Application number: 22305447.9
(22) Date of filing: 04.04.2022
(51) Int. Cl.: G01R 33/38, G01R 33/381, G01R 33/3815, H01F 6/06

(54) **MODULAR MRI MACHINE**

(71) Applicant: Renaissance Fusion, 38600 Fontaine (FR)
(72) Inventor: VOLPE, Francesco, 38600 FONTAINE (FR)
(74) Representative: Cabinet Beaumont

(57) **Abstract**

The present disclosure relates to a modular magnetic resonance imaging machine comprising an assembly of a plurality of modules (100) coupled to each other, wherein the modules have shapes and/or sizes adapted to the shape of the assembly, each module (100) is adapted to conduct current in order to form a magnetic field, and has a first structural section (106) assembled with a second structural section (102), the first structural section having a groove (202) separating the module into at least two different electrically conducting regions.

## Description

### Technical field

The herein disclosed is related to the field of magnetic machines, more particularly to the field of magnetic machines used in medical imaging that are scalable in a modular construction.

### Background art

Doctors and medical practitioners use magnetic imaging techniques to better identify problems in the human body that might be too difficult to diagnose with other methods. Presently, magnetic resonance imaging machines are large devices with a small opening to about the size of a person. For an imaging examination, a person has to stay inside the machine, a at least laterally closed space, for a certain amount of time, this may cause complications to the person being examined including anxiety. Further, to people that suffer from claustrophobia or related medical conditions an MRI exam might be too jarring and therefore impossible.

Presently, MRI machines are constructed with large magnets shaped into coils, which produce a magnetic field. These coils are housed in the machine's support structure. During examination, the coils are excited to form or cause an effect on the magnetic field. The excitation of the field causes a loud noise, sometime described as a hammering. This noise causes discomfort to people and requires that the housing be designed for it. These additional design considerations require the inclusion of noise absorbers and the limiting of materials that may be used to construct the housing.

MRI machines as presently designed and constructed require several magnet coils arranged around the examination area. Coils are arranged in a solenoid configuration, which has a cylindrical hole in the center. The person to be examined rests inside the hole, which is called the examination area or table. The magnetic field in an MRI machine needs to be uniform and homogeneous for proper operation, so there is a need to have stronger magnetic fields closer to the exits of the examination area. Presently, stronger magnetic fields closer to the exits are produced by adding additional magnets coils around them.

The geometry of an MRI machine is therefore limited to the shape of coils. The magnetic fields in MRI applications need to be strong and presently the way to achieve strong enough magnetic fields is through the use of a solenoid arrangement.

An alternative to large coils is described in U.S. Pat. No. 8,838,193 to Maher et al. Maher describes a module that must be used in tandem with other similar modules to form a specific magnetic field configuration. The modules described by Maher should be enough in number and large enough in size, and they must also be positioned and oriented in very specific ways in order to produce a usable magnetic field. Although Maher describes the modules as useful for MRI machines, it is unclear how a uniform and homogeneous magnetic field may be produced throughout an examination area by using such modules. In addition, every module produces its own magnetic field, so if a single module were to fail the whole operation would be unusable during operation. These is a startling limitation of the system as Maher's apparatus may not easily identify which module is malfunctioning. In addition to that, Maher's modules need to be of a specific size in order to operate properly so the geometric configuration and size of an MRI machine constructed out of the modules is limited. It is not clear from Maher's descriptions how a smaller machine to the presently being constructed might be realized. In addition, larger machines that may accommodate different shapes like a half cylinder, a tunnel or a cube may not be realized by use of the described modules.

There are other alternatives for the coil construction, for instance the superconducting coil described in U.S. Pat. No. 8,655,423 to Miyazaki, et al. Miyazaki describes a superconducting coil formed of several layers of different materials. A group of these layers is described as constituting a superconducting coil portion which is formed of thin-film superconducting wires. The coils described by Miyazaki and those that are common in the art are constructed by arranging superconducting films, also called superconducting tapes, into the shape of wires and the wires are then further configured into the shape of coils. According to a review of the prior art, superconducting coils are formed by stacking superconducting films or layers so that electric current may flow in a desired direction and produce the appropriate magnetic field configuration. To the best knowledge and understanding of the inventors, the prior art doesn't teach any other method by which the superconducting films or tapes may be used to conduct a current.

Superconducting tapes themselves are also in short supply, as their demand is increasing year by year. There is also the problem of the size and shape of the tapes which can only be constructed a few centimeters wide. In addition, the process that arranges the tapes into wires and further into coils is lengthy and error prone.

Therefore, it can be summarized that there is an outstanding need for MRI machines that may be constructed in different shapes and sizes. There is also a need for alternatives to large magnet coils that can produce effective magnetic fields even when the housing has a distinct shape like a half cylinder or a cube. In addition, any solution to the current limitations of MRI machines must also solve that the machine may be not aggravate conditions related to anxiety or claustrophobia, must provide a substantially more silent alternative and should reduce overall costs and design complexities. All of these which are limitations of the current art.

### Summary of Invention

One embodiment addresses all or some of the drawbacks of known magnetic resonance imaging (MRI) machines.

One embodiment provides a modular magnetic resonance imaging machine comprising an assembly of a plurality of modules coupled to each other, wherein the modules have shapes and/or sizes adapted to the shape of the assembly, each module is adapted to conduct current in order to form a magnetic field, and has a first structural section assembled with a second structural section, the first structural section having a groove separating the module into at least two different electrically conducting regions.

In one embodiment, the grooves of the plurality of modules are adapted to guide a flow of current into a certain direction, or into different paths, through the modules, and the characteristics of the flow of current through the modules determines the shape of the magnetic field in the machine.

In one or several embodiments:
- at least a module of the plurality of modules is mechanically and/or electrically coupled to another module of the plurality of modules; and/or
- the second structural section of at least a module of the plurality of modules comprises connecting means adapted to connect the module to another module of the plurality of modules, for example a mechanical connector like a hinge or a flange; and/or
- at least a module of the plurality of modules comprises at least a canal that crosses the first structural section, for example to enable a cooling fluid like nitrogen or helium flowing through the module, and/or to allow wiring passing through the module, each canal being for example adapted to form a single canal with a canal of another module of the plurality of modules; and/or
- the first section and the second section of at least a module of the plurality of modules are adapted to be separated.

In one embodiment, at least a module, for example the plurality of modules, is constructed to exhibit superconducting characteristics.

In one embodiment, at least a module of the plurality of modules comprises a stacking of different materials, the stacking comprising at least:
- a structural layer, for example composed or covered by a material like Hastelloy; and
- a superconducting layer on the structural layer, the superconducting layer comprising a superconducting material like yttrium barium copper oxide or a rare-earth barium copper oxide; wherein the groove of the at least one module is patterned at least in the superconducting layer.

In one embodiment, the structural layer includes at least a canal for example to enable a cooling fluid like nitrogen or helium flowing through the module, and/or to allow wiring passing through the module.

In one embodiment, the stacking further comprises at least a buffer layer, preferably a plurality of buffer layers, between the structural layer and the superconducting layer, the at least one buffer layer being for example conformed of materials like alumina, yttria, magnesium oxide and/or lanthanum manganite; wherein the groove is patterned in the at least one buffer layer and the superconducting layer.

In one embodiment, the stacking further comprises a shunt layer on the superconducting layer and in the groove, the shunt layer being made of a metal, for example silver.

In one or several embodiments, the stacking further includes:
- a repeater layer under the shunt layer, the repeater layer comprising a repetition of the buffer and superconducting layers, preferably several repetitions, for example between 4 and 80 repetitions; the groove being patterned in the buffer, the superconducting and the repeater layers; and/or
- a finishing layer on the shunt layer, the finishing layer comprising another preferably non-perforated superconducting layer.

In one particular embodiment, the first structural section includes the structural layer, the at least one buffer layer, the superconducting layer, the repeater layer, the groove and the shunt layer; and/or the second structural section includes the finishing layer.

One embodiment provides a module adapted to the modular magnetic resonance imaging machine according to an embodiment.

The modules may be arranged for example in the shape of a tunnel, a cylinder, a half cylinder, an armband, a half-pipe, a parallelepiped, a box...

One embodiment provides a method for fabricating a module according to an embodiment, the method comprising:
- providing a structural layer;
- depositing, for example by metal-organic chemical vapor deposition, a superconducting layer on the structural layer; and
- removing material at least from the superconducting layer, for example using a laser engraving technique, to form a groove;
- depositing a layer of a metal on the superconducting layer, comprising filling the groove with said metal, for example silver, to form a shunt layer.

In one embodiment, the method further comprises forming, for example using a sputtering technique, at least a buffer layer, preferably a plurality of buffer layers, before forming the superconducting layer, the at least one buffer layer being for example conformed of materials like alumina, yttria, magnesium oxide and/or lanthanum manganite.

In one embodiment, removing material further comprises removing material from the at least one buffer layer.

In one embodiment, the method further comprises forming:
- a repeater layer before forming the groove, the repeater layer comprising the repetition of the buffer and superconducting layers, and preferably several repetitions, for example between 4 and 80 repetitions; and/or
- a finishing layer on the shunt layer, the finishing layer comprising another, preferably non-perforated, superconducting layer.

### Advantages

Advantages of an embodiment of the modular MRI machine may be listed as: simpler and less error prone construction of different modules allowing for faster assembly; high confinement of magnetic fields, due to layers allowing at least partially expelling the magnetic field, like the Meissner effect or a similar effect; servicing of each module is easier and replacement faster, accounting for cheaper device and a reduction of overall costs; coils may be easily changed and replaced, allowing not only for maintenance of the device but also for testing; larger magnetized volumes, making medical imaging possible for anxious, claustrophobic patients, and making it more comfortable for all patients, possibly including the simultaneous imaging of multiple patients; smaller magnetized volumes, on the other hand, making the device portable and suitable for imaging a limb. Other technical advantages will become apparent to someone skilled in the art from the detailed description, figures, and claims. Moreover, while specific advantages have been enumerated above, different embodiments may include all, none or some of the advantages listed.

### Brief description of drawings

The foregoing features and advantages, as well as others, will be described in detail in the following description of specific embodiments given by way of illustration and not limitation with reference to the accompanying drawings, in which:
FIG. 1 is a general perspective view of a first embodiment of a module of the disclosed modular MRI machine.
FIG. 2 is an exploded perspective view of the first embodiment of a module of the disclosed modular MRI machine.
FIG. 3 is a perspective close-up view of the groove in a module of the first embodiment of the disclosed modular MRI machine.
FIG. 4 is a perspective view of a modular MRI machine assembled from the modules according to the first embodiment.
FIG. 5 is a perspective view of a modular MRI machine assembled from the modules according to the first embodiment showing magnetic field lines.
FIG. 6 is a perspective view of a second embodiment of a modular MRI machine assembled from the disclosed modules.
FIG. 7 is a perspective close-up view of the second embodiment of a modular MRI machine assembled from the disclosed modules, showing the machine in an open configuration, and displaying the module separation.
FIG. 8 is a perspective view of a third embodiment of a modular MRI machine assembled from the disclosed modules.
FIG. 9 is a perspective view of a fourth embodiment of a modular MRI machine assembled from the disclosed modules.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 %, and preferably within 5 %.

The figures are not to scale. It should be noted that the drawings refer to an embodiment of the disclosed modular MRI machine, sometimes also referred simply as device or machine, when no ambiguity is anticipated. Other embodiments may be possible, as someone with appropriate training may readily appreciate. The actual dimension and/or shape of each of the components of the embodiment may vary. Only important details of the embodiment are shown, however one of ordinary skill in the art can appreciate how the overall device may be constructed, without undue experimentation. Some details have been omitted from the drawings, but the inventors believe that adding these details is unnecessary for the overall appreciation of the characteristics of the invention disclosed. These omitted details include, among others, elements for holding or fixing the device or its functional components. Some characteristics of the embodiment appear exaggerated to facilitate understanding. The embodiments disclosed, and alternatives observed should not be considered as limiting the invention in any way.

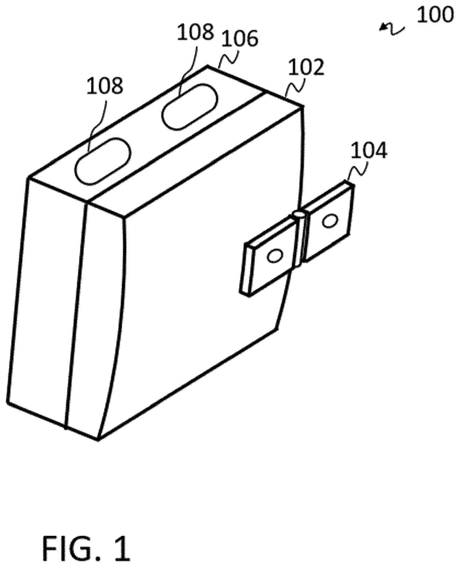

In a first embodiment of the disclosed modular MRI machine, the machine is constructed out of modules **100**. One possible configuration of a module **100** is shown in FIG.1. This module **100** may be divided into two sections, a first structural section **106** which may be fashioned with canals **108** and a second structural section **102**. The canals **108** in the first structural section **106** may be used to transport cooling fluid or some other kind of material to cool the module **100** or otherwise ensure its proper operation. For example, the canals **108** may also be used as housing for wiring. The second structural section **102** may be fashioned with means to connect modules **100** to one another. In a first embodiment, said means conform to a hinge **104** but may also be flanges, connectors or others.

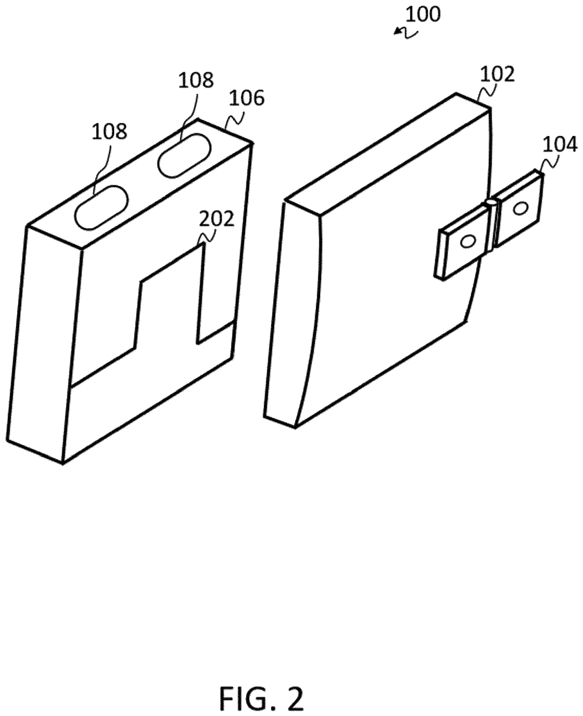

Without limiting the disclosed invention, any module **100** may be constructed in such a way that permits its separation into the first structural section **106** and the second structural section **102**, as shown in FIG. 2. The first structural section **106** may include a pattern defined by a ridge, a wedge or a groove **202**.

The groove **202** separates the first structural section **106** into different electrically conducting regions, so that current may flow in a certain direction, or different paths, according to the needs of the specific use.

When reference is made to a groove, this includes a ridge or a wedge.

### Example of construction of a module

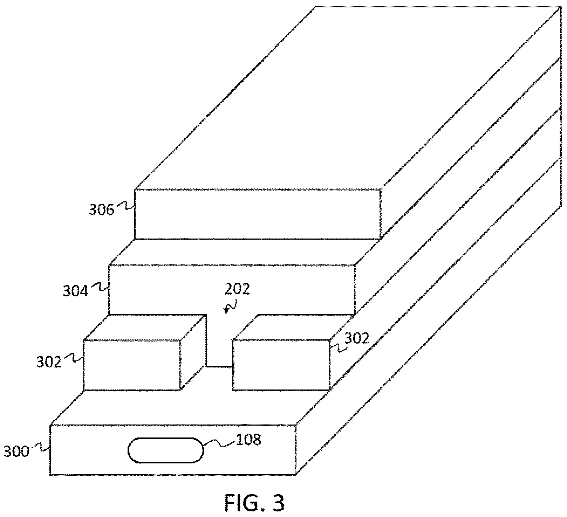

The construction of each module 100 is such that allows for a magnetic field to be formed. Therefore, any module **100** must conduct current, for the formation of a magnetic field. In the first embodiment, current conduction is achieved by the construction of the module **100**, as shown in FIG. 3. The construction of the module **100** according to this first embodiment may be realized by deposition through methods like metal-organic vapor chemical deposition (MOCVD), or similar.

In the first embodiment shown in FIG. 3, the first structural section **106** comprises a structural layer **300** composed of a material like Hastelloy or a material constructed out of a different material and covered by Hastelloy. On top of the Hastelloy structural layer **300**, and forming a layer stack, a superconducting layer **302** is located. The superconducting layer **302** may be deposited with a technique like metal-organic chemical vapor deposition (MOCVD) and is composed of REBCO, YBCO or other appropriate superconducting materials. Buffer layers may be placed between the structural layer **300** and the superconducting layer **302**. The buffer layers may be conformed of several other materials like alumina, yttria, magnesium oxide and lanthanum manganite. These buffer layers may be deposited through a technique like sputtering, before depositing the superconducting layer **302**. The buffer layers may form an appropriate template for the formation of the superconducting layer.

A groove **202** may be created at least through the superconducting layer **302** using a patterning method, like laser engraving, or another technique, like a mechanical technique or photolithography. In some embodiments, the groove may be created also through the buffer layer.

On top of the superconducting layer **302** and filling the groove **202**, a shunt layer **304** may be located. The shunt layer **304** may offer a path in case of quenching of the superconducting layer **302**. The shunt layer **304** may be formed of materials of good electrical conductivity, like silver.

Before forming the groove **202**, the described sequence of buffer and superconducting layers may be repeated several times (forming a repeater layer), with best results being achieved between 4 and 80 of the layer sequence, for example between 20 and 40 repetitions of the layer sequence for magnetic fields of about 10 Tesla. The groove may then also be formed in the repeater layer.

On top of the shunt layer **304**, a finishing layer **306** may be deposited. The finishing layer **306** have a preferably non-perforated (and non-grooved) layer of superconducting material in order to create at least partially the phenomenon known as Meisner effect or a similar effect. The Meisner effect prevents the magnetic field from crossing the finishing layer **306**.

The finishing layer **306** may form part of the second structural section **102**. The first structural section **106** may further include the superconducting layer **302** and the shunt layer **304** in some embodiments, and, in some cases, the repeater layer, as well as the groove **202**. The first structural section **106**, and in particular the structural layer **300**, may also include the canal **108**, for which cooling agents may flow to allow cooling of the whole structure. In particular, the superconducting layer **302** may require adequate cooling during operation.

According to an embodiment, a module is a modular coil.

Other layer configurations and/or methods for constructing a module, for example a modular coil, as a stacked layer of different materials should be apparent to anyone with ordinary skill in the art. Another example of a method or a modular coil is given in European patent application number EP22305437, filed on April 4, 2022 by the same applicant "RENAISSANCE FUSION", entitled "METHOD FOR MANUFACTURING SUPERCONDUCTING COILS AND DEVICE", which is hereby incorporated by reference to the maximum extent allowable by law.

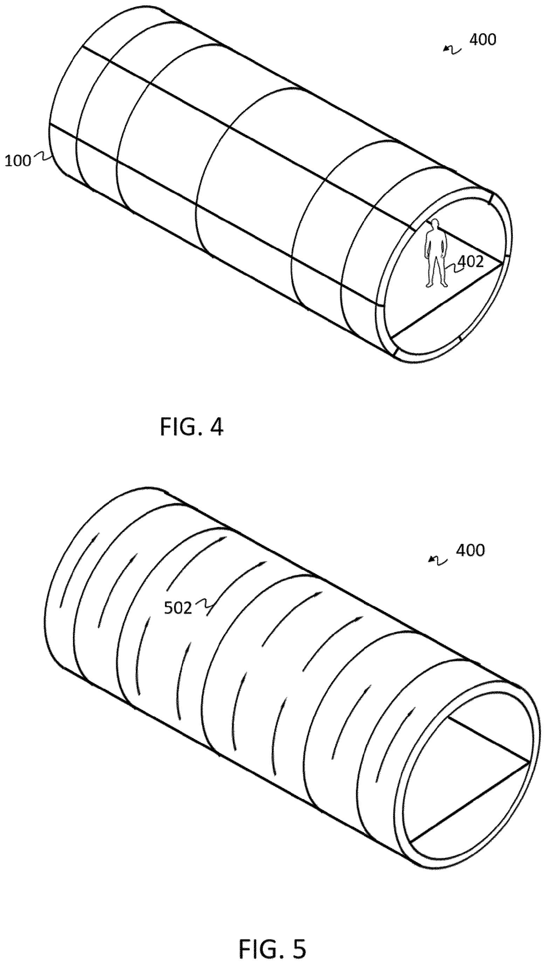

A plurality of modules **100** may be assembled into a modular MRI machine as shown in FIG. 4. The modular MRI machine assembled in this configuration may be called a tunnel **400**. The tunnel **400** is assembled from the modules **100**. The modules **100** may be constructed in different sizes and shapes according to the specific needs of the use. In this first embodiment the tunnel **400** is large enough to house a human being **400** and may be long enough for a person to walk from one side to the other.

### Example of operation

An example of operation of the modular MRI machine is described in reference to the tunnel **400** shown in FIG. 4 and FIG. 5. During operation, the modules **100** that form the structure of the tunnel **400** conduct current **502**. The conduction of current generates a magnetic field, whose field lines would pass through the inside of the tunnel **400**. For applications in magnetic resonance imaging, the magnetic field lines may need to be particularly straight, and the field particularly uniform with respect to space. The configuration of the magnetic field may be changed by changing the characteristics of the current **502** carried by the modules **100**. For instance, the intensity of the current **502** may be changed, or the path the current **502** takes may also be modified.

The tunnel **400** is large enough for a human being **402** to walk comfortably inside. Therefore, people using the tunnel **400** for a medical examination would not suffer from anxieties related to medical conditions like claustrophobia. Nevertheless, it should be understood that the modules may be constructed of any size and other embodiments are also possible.

### Additional Embodiments

The modules **100** may have different shapes and sizes according to the needs of the specific use. The following is a description of other embodiments that may be constructed by utilizing other module **100** shapes and sizes.

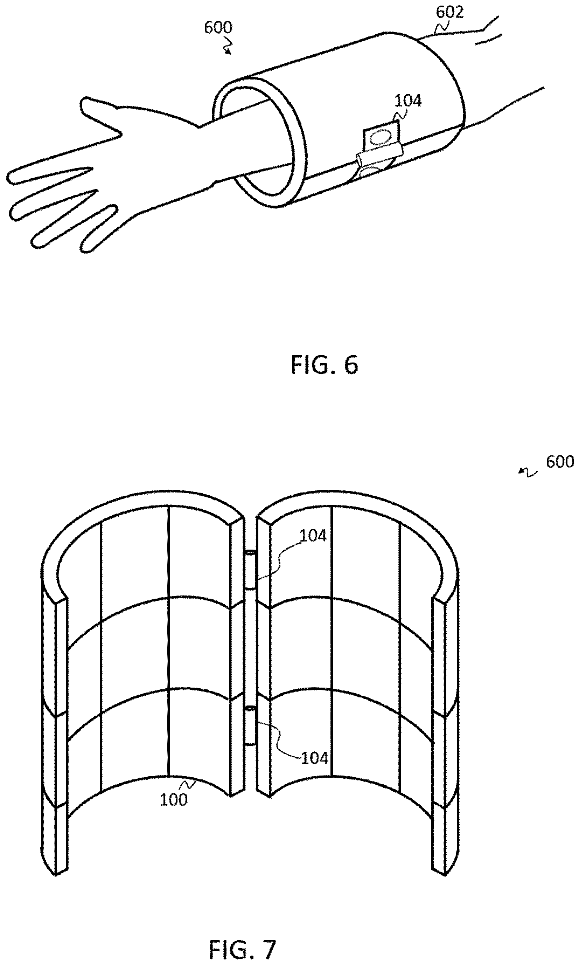

A second embodiment of the modular MRI machine is shown in FIG. 6. This second embodiment may be called an armlet or armband **600**. The armband **600** configuration is assembled from the modules **100** for which the hinge **104** may be used to assemble several of them together. The armband **600** is sized to make a leg or an arm **602** comfortably fit inside.

The armband **600** may be constructed in a manner that allows it to be easily opened and closed as shown in FIG. 7. Further, as also shown in FIG. 7, the modules **100** may be of different sizes and some of them may not have hinges **104**. In the case that hinges are not used, some other method should be used to connect the module **100** together. The connection of the modules **100** may be both mechanical and electrical, according to the needs of the use.

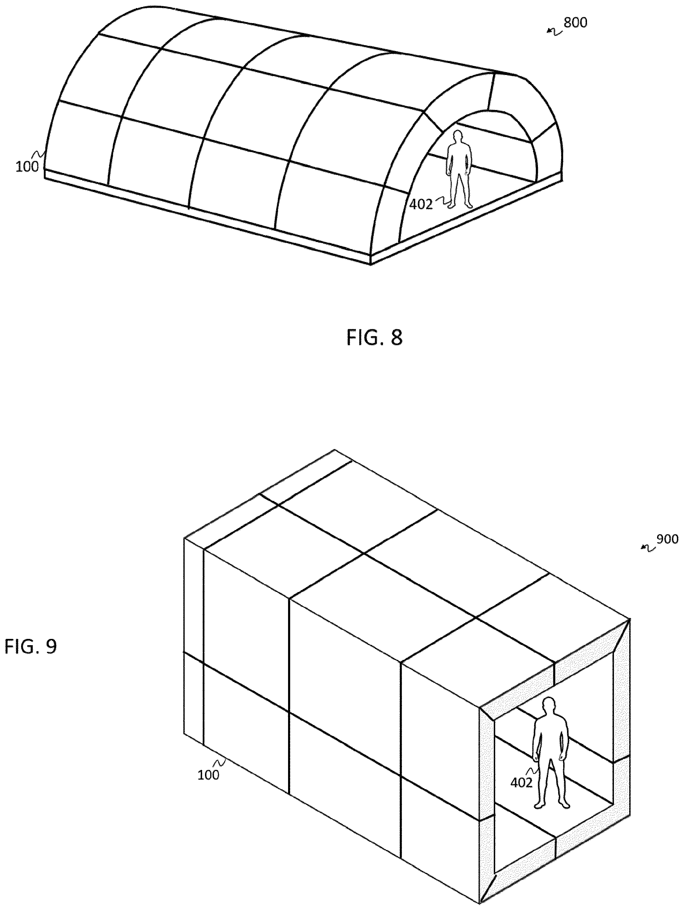

Yet another embodiment is shown in FIG. 8. In this third embodiment the modules **100** are assembled in a half-pipe configuration **800** big enough for a human being **402** to walk inside.

A fourth embodiment is shown in FIG. 9. In this fourth embodiment the modules **100** are assembled in a boxed configuration **900** big enough for a human being **402** to walk inside.

Example embodiments of the invention are summarized here. Other embodiments can also be understood from the entirety of the specification as well as the claims filed herein.

Example 1. A modular magnetic resonance imaging machine (400; 600; 800; 900) comprising an assembly of a plurality of modules (100) coupled to each other, wherein the modules have shapes and/or sizes adapted to the shape of the assembly, each module (100) is adapted to conduct current in order to form a magnetic field, and has a first structural section (106) assembled with a second structural section (102), the first structural section having a groove (202) separating the module into at least two different electrically conducting regions.

Example 2. The machine according to example 1, wherein the grooves of the plurality of modules are adapted to guide a flow of current into a certain direction, or into different paths, through the modules, and the characteristics of the flow of current through the modules determines the shape of the magnetic field in the machine.

Example 3. The machine according to example 1 or 2, wherein at least a module (100) of the plurality of modules is mechanically and/or electrically coupled to another module of the plurality of modules.

Example 4. The machine according to any one of examples 1 to 3, wherein the second structural section (102) of at least a module (100) of the plurality of modules comprises connecting means (104) adapted to connect the module to another module of the plurality of modules, for example a mechanical connector like a hinge or a flange.

Example 5. The machine according to any one of examples 1 to 4, wherein at least a module (100) of the plurality of modules comprises at least a canal (108) that crosses the first structural section (106), for example to enable a cooling fluid like nitrogen or helium flowing through the module, and/or to allow wiring passing through the module, each canal being for example adapted to form a single canal with a canal of another module of the plurality of modules.

Example 6. The machine according to any one of examples 1 to 5, wherein the first section (106) and the second section (102) of at least a module (100) of the plurality of modules are adapted to be separated.

Example 7. The machine according to any one of examples 1 to 6, wherein at least a module, for example the plurality of modules (100), is constructed to exhibit superconducting characteristics.

Example 8. The machine according to any one of examples 1 to 7, wherein at least a module of the plurality of modules comprises a stacking of different materials, the stacking comprising at least:
- a structural layer (300), for example composed or covered by a material like Hastelloy; and
- a superconducting layer (302) on the structural layer (300), the superconducting layer comprising a superconducting material like yttrium barium copper oxide or a rare-earth barium copper oxide; wherein the groove (202) of the at least one module is patterned at least in the superconducting layer.

Example 9. The machine according to example 8, wherein the structural layer (300) includes at least a canal (108) for example to enable a cooling fluid like nitrogen or helium flowing through the module, and/or to allow wiring passing through the module.

Example 10. The machine according to example 8 or 9, wherein the stacking further comprises at least a buffer layer, preferably a plurality of buffer layers, between the structural layer and the superconducting layer, the at least one buffer layer being for example conformed of materials like alumina, yttria, magnesium oxide and/or lanthanum manganite; wherein the groove (202) is patterned in the at least one buffer layer and the superconducting layer.

Example 11. The machine according to any one of examples 8 to 10, wherein the stacking further comprises a shunt layer (304) on the superconducting layer (302) and in the groove (202), the shunt layer being made of a metal, for example silver.

Example 12. The machine according to example 11 in combination with example 10, wherein the stacking further includes:
- a repeater layer under the shunt layer (304), the repeater layer comprising a repetition of the buffer and superconducting layers, preferably several repetitions, for example between 4 and 80 repetitions; the groove (202) being patterned in the buffer, the superconducting and the repeater layers; and/or
- a finishing layer (306) on the shunt layer (304), the finishing layer comprising another preferably non-perforated superconducting layer.

Example 13. The machine according to example 12, wherein the first structural section (106) includes the structural layer (300), the at least one buffer layer, the superconducting layer (302), the repeater layer, the groove (202) and the shunt layer (304); and/or the second structural section (102) includes the finishing layer (306).

Example 14. A module adapted to the magnetic resonance imaging machine according to any one of examples 1 to 13.

Example 15. A method for fabricating a module according to example 14, the method comprising:
- providing a structural layer (300);
- depositing, for example by metal-organic chemical vapor deposition, a superconducting layer (302) on the structural layer (300); and
- removing material at least from the superconducting layer, for example using a laser engraving technique, to form a groove (202);
- depositing a layer of a metal on the superconducting layer, comprising filling the groove with said metal, for example silver, to form a shunt layer (304).

Example 16. The method according to example 15, wherein the method further comprises forming, for example using a sputtering technique, at least a buffer layer, preferably a plurality of buffer layers, before forming the superconducting layer, the at least one buffer layer being for example conformed of materials like alumina, yttria, magnesium oxide and/or lanthanum manganite.

Example 17. The method according to example 16, wherein removing material further comprises removing material from the at least one buffer layer.

Example 18. The method according to any one of examples 15 to 17, wherein the method further comprises forming:
- a repeater layer before forming the groove (202), the repeater layer comprising the repetition of the buffer and superconducting layers, and preferably several repetitions, for example between 4 and 80 repetitions; and/or
- a finishing layer (306) on the shunt layer (304), the finishing layer comprising another, preferably non-perforated, superconducting layer.

Various embodiments and variants have been described. Those skilled in the art will understand that certain features of these embodiments can be combined and other variants will readily occur to those skilled in the art.

Finally, the practical implementation of the embodiments and variants described herein is within the capabilities of those skilled in the art based on the functional description provided hereinabove.

### List of acronyms:

- MRI: Magnetic Resonance Imaging
- MOCVD: Metal-organic chemical vapor deposition
- REBCO: Rare-earth barium copper oxide
- YBCO: Yttrium barium copper oxide.

## Claims

1. A modular magnetic resonance imaging machine (400; 600; 800; 900) comprising an assembly of a plurality of modules (100) coupled to each other, wherein the modules have shapes and/or sizes adapted to the shape of the assembly, each module (100) is adapted to conduct current in order to form a magnetic field, and has a first structural section (106) assembled with a second structural section (102), the first structural section having a groove (202) separating the module into at least two different electrically conducting regions.

2. The machine according to claim 1, wherein the grooves of the plurality of modules are adapted to guide a flow of current into a certain direction, or into different paths, through the modules, and the characteristics of the flow of current through the modules determines the shape of the magnetic field in the machine.

3. The machine according to claim 1 or 2, wherein:
- at least a module (100) of the plurality of modules is mechanically and/or electrically coupled to another module of the plurality of modules; and/or
- the second structural section (102) of at least a module (100) of the plurality of modules comprises connecting means (104) adapted to connect the module to another module of the plurality of modules, for example a mechanical connector like a hinge or a flange; and/or
- at least a module (100) of the plurality of modules comprises at least a canal (108) that crosses the first structural section (106), for example to enable a cooling fluid like nitrogen or helium flowing through the module, and/or to allow wiring passing through the module, each canal being for example adapted to form a single canal with a canal of another module of the plurality of modules; and/or
- the first section (106) and the second section (102) of at least a module (100) of the plurality of modules are adapted to be separated.

4. The machine according to any one of claims 1 to 3, wherein at least a module, for example the plurality of modules (100), is constructed to exhibit superconducting characteristics.

5. The machine according to any one of claims 1 to 4, wherein at least a module of the plurality of modules comprises a stacking of different materials, the stacking comprising at least:
- a structural layer (300), for example composed or covered by a material like Hastelloy; and
- a superconducting layer (302) on the structural layer (300), the superconducting layer comprising a superconducting material like yttrium barium copper oxide or a rare-earth barium copper oxide; wherein the groove (202) of the at least one module is patterned at least in the superconducting layer.

6. The machine according to claim 5, wherein the structural layer (300) includes at least a canal (108) for example to enable a cooling fluid like nitrogen or helium flowing through the module, and/or to allow wiring passing through the module.

7. The machine according to claim 5 or 6, wherein the stacking further comprises at least a buffer layer, preferably a plurality of buffer layers, between the structural layer and the superconducting layer, the at least one buffer layer being for example conformed of materials like alumina, yttria, magnesium oxide and/or lanthanum manganite; wherein the groove (202) is patterned in the at least one buffer layer and the superconducting layer.

8. The machine according to any one of claims 5 to 7, wherein the stacking further comprises a shunt layer (304) on the superconducting layer (302) and in the groove (202), the shunt layer being made of a metal, for example silver.

9. The machine according to claim 8 in combination with claim 7, wherein the stacking further includes:
- a repeater layer under the shunt layer (304), the repeater layer comprising a repetition of the buffer and superconducting layers, preferably several repetitions, for example between 4 and 80 repetitions; the groove (202) being patterned in the buffer, the superconducting and the repeater layers; and/or
- a finishing layer (306) on the shunt layer (304), the finishing layer comprising another preferably non-perforated superconducting layer.

10. The machine according to claim 9, wherein the first structural section (106) includes the structural layer (300), the at least one buffer layer, the superconducting layer (302), the repeater layer, the groove (202) and the shunt layer (304); and/or the second structural section (102) includes the finishing layer (306).

11. A module adapted to the magnetic resonance imaging machine according to any one of claims 1 to 10.

12. A method for fabricating a module according to claim 11, the method comprising:
- providing a structural layer (300);
- depositing, for example by metal-organic chemical vapor deposition, a superconducting layer (302) on the structural layer (300); and
- removing material at least from the superconducting layer, for example using a laser engraving technique, to form a groove (202);
- depositing a layer of a metal on the superconducting layer, comprising filling the groove with said metal, for example silver, to form a shunt layer (304).

13. The method according to claim 12, wherein the method further comprises forming, for example using a sputtering technique, at least a buffer layer, preferably a plurality of buffer layers, before forming the superconducting layer, the at least one buffer layer being for example conformed of materials like alumina, yttria, magnesium oxide and/or lanthanum manganite.

14. The method according to claim 13, wherein removing material further comprises removing material from the at least one buffer layer.

15. The method according to any one of claims 12 to 14, wherein the method further comprises forming:
- a repeater layer before forming the groove (202), the repeater layer comprising the repetition of the buffer and superconducting layers, and preferably several repetitions, for example between 4 and 80 repetitions; and/or
- a finishing layer (306) on the shunt layer (304), the finishing layer comprising another, preferably non-perforated, superconducting layer.
